# EUROPÄISCHE PATENTSCHRIFT

(11) **EP 3 957 774 B1**
(45) Veröffentlichungstag und Bekanntmachung des Hinweises auf die Patenterteilung: **07.12.2022**
(21) Anmeldenummer: 20191715.0
(22) Anmeldetag: 19.08.2020
(51) Int. Cl.: C30B 13/20, C30B 13/24, C30B 29/06

(54) **VERFAHREN UND ANLAGE ZUM ZIEHEN EINES EINKRISTALLS NACH DEM FZ-VERFAHREN**
METHOD AND SYSTEM FOR DRAWING A SINGLE CRYSTAL USING THE FZ METHOD
PROCÉDÉ ET INSTALLATION DE TIRAGE D'UN MONOCRISTAL SELON LE PROCÉDÉ FZ

(43) Veröffentlichungstag der Anmeldung: 23.02.2022
(73) Patentinhaber: Siltronic AG, 81677 München (DE)
(72) Erfinder: Brenninger, Georg, 84564 Oberbergkirchen (DE); Meisterernst, Götz, 84562 Mettenheim (DE)
(74) Vertreter: Staudacher, Wolfgang

(56) Entgegenhaltungen:
- CN-A- 108 070 901
- US-A1- 2016 053 401

## Beschreibung

Die vorliegende Erfindung betrifft ein Verfahren zum Ziehen eines Einkristalls nach dem FZ-Verfahren, bei dem ein Stab aus polykristallinem Halbleitermaterial mittels einer elektromagnetischen Schmelzvorrichtung geschmolzen und anschließend als Einkristall auskristallisiert wird, sowie eine Anlage zur Durchführung des Verfahrens.

### Stand der Technik

Beim Ziehen von Einkristallen, insbesondere aus Halbleitermaterial wie z.B. Silizium, nach dem FZ-Verfahren, dem sogenannten Floating-Zone-Verfahren bzw. Zonenziehverfahren, können sehr reine Einkristalle erzeugt werden. Hierbei wird ein Stab aus polykristallinem Halbleitermaterial (nachfolgend als Polykristall bezeichnet) geschmolzen und anschließend als Einkristall auskristallisiert. Zum Schmelzen wird typischerweise eine Hochfrequenz-Spule (HF-Spule oder Induktionsheizspule) verwendet. Die DE 10 2005 060 391 A beschreibt z.B. ein solches FZ-Verfahren.

Bei einem solchen Verfahren kommt es, insbesondere bei Einkristallen mit Durchmessern von 200 mm und darüber, gelegentlich zu Versetzungen im Einkristall, was in aller Regel die Verwendung des Einkristalls für die Herstellung von einkristallinen Halbleiterscheiben unmöglich macht.

Ein Grund für solche Versetzungen können z.B. Temperaturgradienten im Bereich der Phasengrenze sein, an der der Einkristall kristallisiert.

Aus der DE 36 25 669 A1 ist für ein solches FZ-Verfahren z.B. ein sog. Nachheizer bekannt. Ein solcher Nachheizer kann in Ziehrichtung nach der HF-Spule angeordnet werden, also in einem Bereich, in dem die Schmelze wieder erstarrt. Damit kann die Abkühlung insbesondere an der Außenseite des Stabes verlangsamt werden, was zu geringeren Temperaturgradienten in radialer Richtung führt.

In CN 108 070 901 A wird eine Zusatzheizung vorgeschlagen, die Reflektorringe und Laser umfasst.

US2016053401 offenbart eine Zusatzheizung für einen Zonenschmelzofen, wobei die Zusatzheizung unterhalb der Primärheizspule angeordnet ist und es ermöglicht, die Temperaturverteilung im Einkristall zu verbessern.

Ein weiteres Problem, das bei der Herstellung von Einkristallen nach dem FZ-Verfahren auftritt, ist eine ungleichmäßige Verteilung von Dotierstoffen im Halbleitermaterial, was letztlich zu einem ungleichmäßigen spezifischen elektrischen Widerstand (resistivity) im Volumen des Einkristalls führt. Diese ungleichmäßige Verteilung der Dotierstoffe hat auch mit der Temperaturverteilung und mit Temperaturgradienten im Einkristall zu tun.

Vor diesem Hintergrund stellt sich die Aufgabe, eine Möglichkeit zur Herstellung besserer Einkristalle zur Verfügung zu stellen.

### Offenbarung der Erfindung

Die Aufgabe der Erfindung wird gelöst durch ein Verfahren zum Ziehen eines Einkristalls nach dem FZ-Verfahren, bei dem ein Stab aus polykristallinem Halbleitermaterial mittels einer elektromagnetischen Schmelzvorrichtung geschmolzen und anschließend als Einkristall auskristallisiert wird, wobei mittels einer Zusatzheizvorrichtung eine in Umfangsrichtung des Einkristalls auftretende, ungleichmäßige Verteilung der Temperatur des Einkristalls zumindest teilweise ausgeglichen wird, dadurch gekennzeichnet, dass der Einkristall mittels der Zusatzheizvorrichtung selektiv an kälteren Positionen seines Umfangs zusätzlich erhitzt wird.

Gegenstand der Erfindung ist des Weiteren eine Anlage mit einer elektromagnetischen Schmelzvorrichtung zum Ziehen eines Einkristalls nach dem FZ-Verfahren, umfassend eine Zusatzheizvorrichtung, die eine in Umfangsrichtung des Einkristalls auftretende, ungleichmäßige Verteilung einer Temperatur des Einkristalls zumindest teilweise ausgleicht, gekennzeichnet durch eine Regelungseinrichtung, die einen Wärmeeintrag der Zusatzheizvorrichtung (230) auf Positionen am Umfang der Einkristalls beschränkt.

Nachfolgend soll der Vorgang des FZ-Verfahrens, der an sich bekannt ist, kurz erläutert werden. Hierzu wird der Polykristall, der in aller Regel stabförmig mit einem Durchmesser von beispielsweise 160 mm oder mehr, insbesondere auch 200 mm oder mehr, ausgebildet ist, zunächst mittels der Schmelzvorrichtung, beginnend an einem (in Bezug zur Schwerkraft bei vertikaler Anordnung des stabförmigen Polykristalls) unteren Ende, aufgeschmolzen. Hierbei kann durch Anregung mittels Hochfrequenz elektromagnetische Energie in den Polykristall, der in die Nähe der HF-Spule gebracht wird, eingekoppelt werden.

Dabei kann der Polykristall, der an seinem unteren Ende in aller Regel konisch ausgebildet ist, abgesenkt und an ein mittiges Loch in der HF-Spule herangeführt werden. Der Polykristall beginnt dann am unteren Ende zu schmelzen, wobei sich zunächst ein Tropfen flüssigen Materials bildet, der am Polykristall hängt. Dann wird in der Regel ein einkristalliner Impfling, der insbesondere ebenfalls stabförmig ausgebildet ist und einen Durchmesser von beispielsweise ca. 4 bis 7 mm aufweist, an das untere Ende des Polykristalls und damit an den Tropfen flüssigen Materials, angebracht und dann beginnend von einem oberen Ende des Impflings an geschmolzen. Das Schmelzen des Impflings beginnt dabei in der Regel erst, nachdem sich die Temperatur des Impflings an diejenige des bereits flüssigen Materials angeglichen hat. Zum Schmelzen des Impflings wird der Impfling nach oben bewegt.

Danach wird nun zwischen einem unteren Abschnitt des Impflings (an dem dieser beispielsweise in der erwähnten Ziehvorrichtung gehalten werden kann) und dem Polykristall (also dem noch festen und noch nicht geschmolzenen Anteil des Polykristalls) ein Dünnhals-Abschnitt gebildet, dessen Durchmesser geringer als derjenige des Impflings ist. Dieser Dünnhals-Abschnitt wird gebildet, um etwaige Versetzungen, die sich beispielsweise durch das Anbringen des Impflings an das flüssige Material am Polykristall, bilden, zu entfernen. Der Durchmesser des Dünnhals-Abschnitts kann dabei beispielsweise zwischen 2 und 4 mm betragen. Nach dem Dünnhals-Abschnitt kann dann der Durchmesser des Einkristalls bis zu einem gewünschten Durchmesser von vorzugsweise mindestens 200 mm erhöht und dann beibehalten werden.

Wie schon erwähnt, kann es beim Wachsen des Einkristalls zu starken (insbesondere radialen) Temperaturgradienten kommen. Um dem damit einhergehenden unterschiedlich schnellen Erstarren bzw. Auskristallisieren und dabei möglicherweise entstehenden Versetzungen entgegenzuwirken, kann eine Nachheizvorrichtung verwendet werden, mit der Temperaturgradienten in radialer und/oder axialer Richtung des Einkristalls reduziert werden. Eine solche Nachheizvorrichtung kann insbesondere auch passiv ausgebildet sein, z.B. als sich gleichmäßig über den Umfang erstreckender Ring aus besonders gut reflektierendem Material, wobei poliertes Silber besonders geeignet ist.

Konstruktionsbedingt erzeugt die HF-Spule, die in aller Regel einen Hauptschlitz aufweist (hierzu sei auch auf die Figurenbeschreibung verwiesen), an der umfänglichen Position dieses Hauptschlitzes eine höhere Schmelzenergie, was zu örtlich höheren Temperaturen entlang des Umfangs des Einkristalls führt. Die Temperatur am Umfang des Einkristalls ist tendenziell in den Bereichen kälter, die zum Hauptschlitz der HF-Spule den größeren Abstand haben.

Eine Möglichkeit, in begrenztem Maß dagegen vorzugehen, ist, eine sog. Wechseldrehung des Einkristalls vorzusehen. Hierbei wird der Einkristall abwechselnd im Uhrzeigersinn und gegen den Uhrzeigersinn gedreht, beispielsweise mit einer Rotationsgeschwindigkeit von 16 Umdrehungen pro Minute. Typisch und zweckmäßig ist hierbei eine unterschiedliche Rotationsdauer oder Rotationsweite zwischen Drehung im Uhrzeigersinn und im Gegenuhrzeigersinn, sodass sich als Resultat eine effektive Drehung in eine der beiden Richtungen ergibt.

Darüber hinaus ist bekannt, dass ein Einkristall am Umfang Ziehkanten (habit lines) ausbildet, weil das Material in bestimmten Kristallrichtungen schneller wächst als in anderen. Einkristalle aus Silizium, die in einer <100>-Richtung gezogen werden, bilden beispielsweise vier Ziehkanten im Abstand von 90 ° aus. An Ziehkanten kühlt der Einkristall schneller, als in den Bereichen dazwischen, wodurch Temperaturgradienten entstehen, die eine ungleichmäßige Verteilung von Dotierstoffen im Einkristall bewirken. Entlang des Umfangs des Einkristalls schwankt die Dotierstoff-Konzentration sinusförmig, wobei der spezifische elektrische Widerstand in den Bereichen der Ziehkanten niedriger ist, als in den Bereichen zwischen den Ziehkanten.

Im Rahmen der Erfindung wird nun vorgeschlagen, mittels einer Zusatzheizvorrichtung eine in Umfangsrichtung des Einkristalls auftretende, ungleichmäßige Verteilung einer Temperatur des Einkristalls zumindest teilweise auszugleichen und zwar, indem der Einkristall mittels der Zusatzheizvorrichtung selektiv an kälteren Positionen des Umfangs erhitzt wird. Grundsätzlich ist es möglich, zu diesem Zweck die Temperatur des Einkristalls am Umfang im Bereich der Phasengrenze zu messen und so die kälteren Positionen zu identifizieren. Die kälteren Positionen haben vorzugsweisen einen Abstand von bis zu 10 mm zur Phasengrenze, an der der Einkristall kristallisiert. Alternativ zum Bestimmen der kälteren Positionen durch Messung der Temperatur kommen als kältere Positionen insbesondere die Positionen von Ziehkanten in Betracht.

Bei einer solchen Zusatzheizvorrichtung - die erwähnte Nachheizvorrichtung kann zusätzlich verwendet werden - handelt es sich vorzugsweise um eine Laserlichtquelle. Mit der vorgeschlagenen Zusatzheizvorrichtung kann also der ungleichmäßigen, umfänglichen Temperaturverteilung, deren Ursache die Ziehkanten sind und deren Folge ungleichmäßige Dotierstoffkonzentrationen bzw. Widerstandsverteilungen sind, entgegengewirkt werden.

Gemäß einer Ausgestaltung des Verfahrens werden kältere Positionen am Umfang des Einkristalls mittels Temperaturmessung ermittelt, und der Einkristall an diesen Positionen mittels der Zusatzheizvorrichtung zusätzlich erhitzt, so dass der Temperaturunterschied kleiner wird oder verschwindet. Eine Temperaturmessung kann hier z.B. anhand einer Analyse der (Wärme-)Strahlung des Einkristalls über den Umfang erfolgen. Auf diese Weise kann der Einkristall besonders genau und zielgerichtet erwärmt werden bzw. ungleichmäßige Temperaturverteilungen können besonders genau und zielgerichtet ausgeglichen werden. Zweckmäßig ist hierbei auch eine Automatisierung, insbesondere auch mit einer Regelung, sodass z.B. die Erwärmung des Einkristalls mittels der Zusatzheizvorrichtung ständig anhand der aktuell gemessenen Temperaturen angepasst bzw. nachgeführt wird. Insbesondere kann damit auch die schon erwähnte Wechseldrehung des Einkristalls - wenn eine solche verwendet wird - berücksichtigt werden.

Gemäß einer anderen Ausgestaltung des Verfahrens wird der Einkristall mittels der Zusatzheizvorrichtung selektiv an Positionen von Ziehkannten zusätzlich erhitzt, um den Temperaturunterschied zu den daran angrenzenden Bereichen zu reduzieren oder zu eliminieren. Auch in diesem Fall ist es bevorzugt, eine Regelung einzusetzen, die das Aktivieren und Deaktivieren der Zusatzheizvorrichtung gegebenenfalls unter Berücksichtigung der Wechseldrehung des Einkristalls so synchronisiert, dass die Zusatzeinrichtung nur die zusätzlich zu erhitzenden Positionen erreicht.

Besonders vorteilhaft ist es, eine Zusatzheizvorrichtung mit einer Laserlichtquelle zu verwenden, deren Laserlicht mittels wenigstens einer optischen Einrichtung an den Einkristall gelenkt wird. Eine Laserlichtquelle (Laser) kann besonders zielgenau und auch einfach eingesetzt werden. Dabei kann z.B. mit nur einer solchen optischen Einrichtung trotzdem jeder (mehr oder weniger) beliebige Punkt entlang des Umfangs des Kristalls erreicht werden, wenn bzw. indem die erwähnte Wechseldrehung des Kristalls mit berücksichtigt wird.

Das erfindungsgemäße Verfahren macht einen stabförmigen Einkristall aus Halbleitermaterial zugänglich, bei dem der spezifische elektrische Widerstand innerhalb einer Querschnittsfläche senkrecht zu einer Achse des stabförmigen Einkristalls um höchstens 2 % variiert, wobei die Variation (RRV) definiert ist mittels der Gleichung RRV = 100% x (Rₘₐₓ - Rₘᵢₙ) / Rₘᵢₙ und wobei ein Randauschluss (edge exclusion) von 6 mm berücksichtigt ist. Rₘₐₓ beziehungsweise Rₘᵢₙ bezeichnen den größten beziehungsweise den kleinsten spezifischen elektrischen Widerstand, gemessen entlang des Radius an mindestens 3 Stellen.

Vorzugsweise weicht der spezifische elektrische Widerstand in der Querschnittsfläche in Sektoren, die jeweils einer der Ziehkanten zugeordnet sind, einen Winkel von 20° aufweisen und gleichmäßig um die Ziehkanten angeordnet sind, um höchstens 6 % vom spezifischen elektrischen Widerstand in der Querschnittsfläche außerhalb der Sektoren ab.

Als Halbleitermaterial ist Silizium bevorzugt, ebenso wie ein Durchmesser von mindestens 200 mm des Einkristalls. Als Dotierstoffe kommen vorzugsweise Bor oder Phosphor in Betracht.

Weitere Vorteile und Ausgestaltungen der Erfindung ergeben sich aus der Beschreibung und den beiliegenden Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

Fig. 1 zeigt schematisch eine erfindungsgemäße Anlage in einer bevorzugten Ausführungsform, mit der auch ein erfindungsgemäßes Verfahren durchführbar ist.
Fig. 2 zeigt einen Teil der Anlage aus Fig. 1 in einer Draufsicht.
Fig. 3 zeigt einen Teil der Anlage aus Fig. 1 in einer Schnittansicht

### Merkmalsliste:

- 100: Halbleitermaterial
- 101: Polykristall
- 102: Schmelze
- 103: Einkristall
- 110: Ziehkanten
- 120: Dotierstoff
- 200: Anlage
- 202: Reaktor
- 210: elektromagnetische Schmelzvorrichtung
- 212: HF-Spule
- 214: Hauptschlitz
- 216: Nebenschlitze
- 218: Ansteuereinheit
- 220: Nachheizvorrichtung
- 230: Zusatzheizvorrichtung
- 232: Laserlichtquelle
- 234: optische Einrichtungen
- 236: Lichtwellenleiter
- 238: Laserlicht
- 240: Temperaturmesseinrichtung
- 250: Regelungseinrichtung
- d: Doppelpfeile
- d_{E}: Durchmesser Einkristall
- d_{P}: Durchmesser Polykristall
- P: Positionen am Einkristall
- R_{A}: axiale Richtung
- R_{U}: Umfangsrichtung
- R_{R}: radiale Richtung
- S: Sektoren

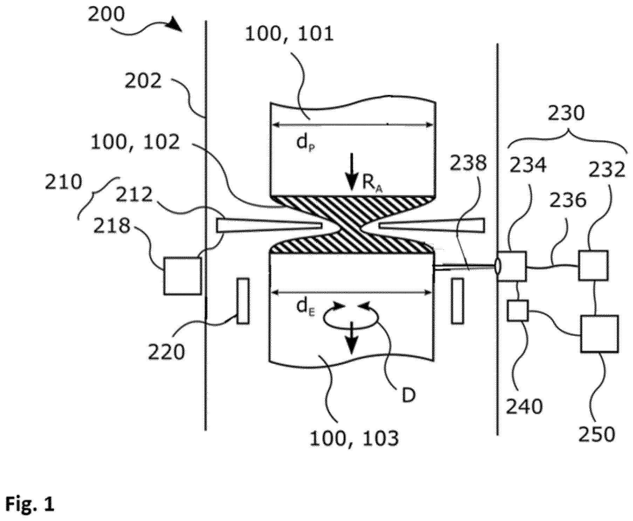

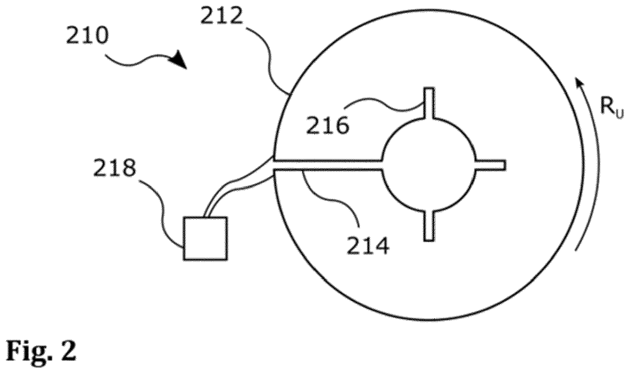

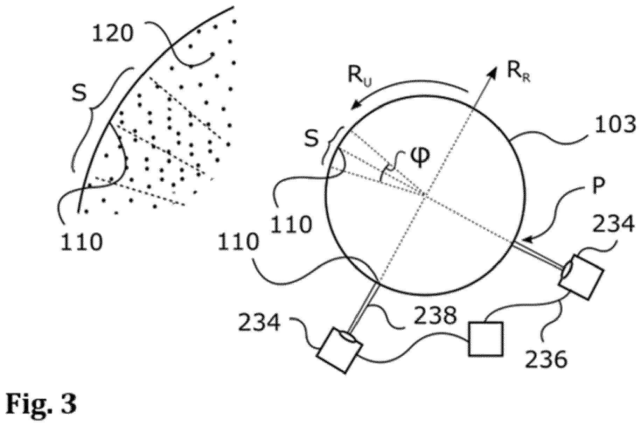

In Figur 1 ist schematisch eine erfindungsgemäße Anlage 200 in einer bevorzugten Ausführungsform dargestellt, mit der auch ein erfindungsgemäßes Verfahren durchführbar ist. Die Anlage 200 sowie eine bevorzugte Ausführungsform des erfindungsgemäßen Verfahrens sollen anhand der Figur 1 sowie der Ansichten in den Figuren 2 und 3 nachfolgend übergreifend beschrieben werden.

Die Anlage 200 dient zum Ziehen eines Einkristalls nach dem sog. FZ-Verfahren und weist einen nur schematisch angedeuteten Reaktor 202 auf, in dem im Verlauf des Verfahrens ein Polykristall 101 und ein Einkristall 103 aus einem Halbleitermaterial 100, z.B. Silizium, ggf. mit einem Dotierstoff, angeordnet sind. Der Polykristall 101 hat einem Durchmesser d_{P}, der Einkristall 103 einen Durchmesser d_{E}. Zwischen Polykristall 101 und Einkristall 103 befindet sich eine Schmelze 102.

Weiterhin sind eine elektromagnetische Schmelzvorrichtung 210, eine Nachheizvorrichtung 220, eine Zusatzheizvorrichtung 230, eine Temperaturmesseinrichtung 240 sowie eine Steuer- und Regeleinrichtung 250 vorgesehen, die nachfolgend näher beschrieben werden sollen.

Wie eingangs schon erwähnt, wird der Polykristall 101 mittels der elektromagnetischen Schmelzvorrichtung 210 aufgeschmolzen, dann wird ein einkristalliner Impfling angebracht, sodass das aufgeschmolzene Halbleitermaterial als Einkristall wieder erstarrt. Dieser Beginn des FZ-Verfahrens bzw. dessen konkrete Ausgestaltung ist für die vorliegende Erfindung nicht von besonderem Interesse und daher nicht dargestellt.

In Figur 1 ist vielmehr eine Situation während des Ziehens dargestellt, in der oberhalb der elektromagnetischen Schmelzvorrichtung 210 der Polykristall 101 an einer (hier nicht dargestellten) Aufhängung hängt und nach unten in einer axialen Richtung R_{A} abgesenkt wird. Auf Höhe der elektromagnetischen Schmelzvorrichtung 210 befindet sich dann die Schmelze 102 und darunter der erstarrte Einkristall 103, der ggf. an einer hier nicht dargestellten Stütze angebracht ist und ebenfalls in der axialen Richtung R_{A} abgesenkt wird.

Die elektromagnetische Schmelzvorrichtung 210 ist als HF-Spule 212 ausgebildet, die mittels einer Ansteuereinheit 218, die über entsprechende Leitungen angeschlossen ist, mit Hochfrequenz angesteuert werden kann.

In Figur 2 ist die elektromagnetische Schmelzvorrichtung 210 in einer anderen Ansicht, hier einer Draufsicht, dargestellt. Hier ist nun deutlich eine Ausnehmung bzw. ein Loch in der Mitte der HF-Spule 212 zu sehen, durch welches sich die Schmelze erstreckt.

Insbesondere sind hier nun auch ein Hauptschlitz 214 sowie drei Nebenschlitze 216 zu sehen, wobei insbesondere der Hauptschlitz 214 für die Funktion der elektromagnetischen Schmelzvorrichtung, insbesondere zu Erzeugung der elektromagnetischen Energie, nötig ist. Die elektromagnetische Energie, die im Bereich des Hauptschlitzes 214 erzeugt wird, ist höher als in den anderen Bereichen in Umfangsrichtung Ru, sodass dort ein erhöhter Energieeintrag im Einkristall 103 auftritt, der zu Temperaturunterschieden führt. Trotz der schon erwähnten und in Figur 1 mit den Doppelpfeilen D dargestellten Wechseldrehung kann dieser Effekt nicht vollständig ausgeglichen werden, sodass eine ungleichmäßige Verteilung der Temperatur in Umfangsrichtung Ru des Einkristalls 103 verbleibt.

In Figur 1 ist beispielhaft eine passive Nachheizvorrichtung 220 vorgesehen, bei der es sich beispielsweise um einen Ring aus reflektierendem Material handeln kann. Sie umgibt den wachsenden Einkristall 103 nahe der Phasengrenze zur Schmelze 102.

Weiterhin ist in Figur 1 die Zusatzheizvorrichtung 230 gezeigt, die nachfolgend auch unter Bezug auf Figur 3 näher erläutert werden soll. Die Zusatzheizvorrichtung 230 weist beispielhaft eine Laserlichtquelle 232 auf, die über Lichtwellenleiter 236 an optische Einrichtungen 234 angebunden ist. Mittels dieser optischen Einrichtungen 234 kann Laserlicht 238 auf gewünschte Positionen P an den Einkristall 103 gelenkt werden, wodurch das Halbleitermaterial 100 erwärmt wird.

Beispielhaft sind in Figur 3 zwei optische Einrichtungen 234 gezeigt, es versteht sich jedoch, dass beispielsweise je nach Erfordernis oder Wunsch nur eine oder weitere solcher optischen Einrichtungen oder auch andersartig aufgebaute optische Einrichtungen verwendet werden können. Durch die Verwendung einer oder mehrerer optischer Einrichtungen ein Laserstrahl gewünschter Intensität an jede Position des Kristalls in Umfangsrichtung Ru gelenkt werden kann, beispielsweise auch unter Berücksichtigung einer Wechseldrehung des Einkristalls.

Auf diese Weise ist es also möglich, eine ungleichmäßige Verteilung der Temperatur des Einkristalls in Umfangsrichtung Ru gezielt auszugleichen.

Gemäß der dargestellten Ausführungsform ist eine Temperaturmesseinrichtung 240 vorgesehen, mittels welcher z.B. Wärmestrahlung, die vom Einkristall 103 abgestrahlt wird und auf die optische(n) Einrichtung(en) 234 eingestrahlt wird, erfasst werden kann, um so eine möglichst genaue Temperaturverteilung der Oberfläche des Einkristalls 103 zu erhalten, wodurch wiederum eine gezielte Erwärmung möglich ist.

Zu diesem Zweck wird die Regelungseinrichtung 250 eingesetzt, die die erfasste Temperatur als eine Eingangsgröße erhält und basierend darauf eine geeignete Ansteuerung der Zusatzheizvorrichtung 230 durchführt oder veranlasst.

Die Regelungseinrichtung kann alternativ oder zusätzlich mit einem Kamerasystem in Verbindung stehen, das die Position von Ziehkanten 110 ermittelt, und die Zusatzheizvorrichtung 230 aktivieren, um Positionen am Umfang des Einkristalls 103 im Bereich der Ziehkanten selektiv zu erhitzen. In Figur 3 sind hierzu beispielhaft Ziehkanten 110 angedeutet, die durch die Kristallstruktur und die Kristallisation entstehen. Dort tritt eine stärkere Wärmeabstrahlung auf als in den übrigen Bereichen des Umfangs bzw. in Umfangsrichtung Ru, was zu einem schnelleren Erstarren in diesen Bereichen der Ziehkanten 110 führt. Dies wiederum führt zu einer veränderten Konzentration eines Dotierstoffs, nicht nur in Umfangsrichtung Ru, sondern auch in radialer Richtung R_{R}.

Hierzu ist in dem vergrößert darstellten Ausschnitt aus der Schnittansicht mit der Ziehkante 110 (links in Figur 3) zu sehen, dass ein Dotierstoff 120 im Bereich um die Ziehkante 110 eine andere Konzentration aufweist als in Umfangsrichtung gesehen weiter weg von der Ziehkante. Durch die gezielte Erwärmung des Kristalls an den Ziehkanten 110 im Rahmen der vorliegenden Erfindung ist es möglich, die Variation des elektrischen Widerstand innerhalb der (z.B. in Figur 3 gezeigten) Querschnittsfläche des Einkristalls 103 (die senkrecht zur Achse des Einkristalls, die sich entlang der axialen Richtung R_{A} gemäß Figur 1 erstreckt, liegt) auf nicht mehr als 2 % zu beschränken. Insbesondere ist es auch möglich, dass der elektrische Widerstand in Sektoren S, die jeweils einer der Ziehkanten 110 zugeordnet sind, einen Winkel ϕ von 20° aufweisen und gleichmäßig um die Ziehkanten 110 angeordnet sind, um höchstens 2 % vom elektrischen Widerstand außerhalb dieser Sektoren S abweicht.

## Patentansprüche

1. Verfahren zum Ziehen eines Einkristalls (103) nach dem FZ-Verfahren, bei dem ein Stab aus polykristallinem Halbleitermaterial (101) mittels einer elektromagnetischen Schmelzvorrichtung (210) geschmolzen und anschließend als Einkristall auskristallisiert wird,
wobei mittels einer Zusatzheizvorrichtung (230) eine in Umfangsrichtung (Ru) des Einkristalls (103) auftretende, ungleichmäßige Verteilung der Temperatur des Einkristalls (103) zumindest teilweise ausgeglichen wird,
**dadurch gekennzeichnet, dass** der Einkristall (100) mittels der Zusatzheizvorrichtung (230) selektiv an kälteren Positionen seines Umfangs zusätzlich erhitzt wird.

2. Verfahren nach Anspruch 1, **dadurch gekennzeichnet, dass** der Einkristall (100) mittels der Zusatzheizvorrichtung (230) selektiv an Positionen von Ziehkanten (110) zusätzlich erhitzt wird.

3. Verfahren nach Anspruch 1 oder 2, **dadurch gekennzeichnet, dass** die kälteren Positionen durch Messen der Temperatur bestimmt werden.

4. Verfahren nach einem der Ansprüche 1 bis 3, bei dem eine Zusatzheizvorrichtung (230) verwendet wird, die eine Laserlichtquelle (232) aufweist, deren Laserlicht (238) mittels wenigstens einer optischen Einrichtung (234) an den Einkristall (100) gelenkt wird.

5. Verfahren nach einem der Ansprüche 1 bis 4, wobei der Einkristall (103) mittels Wechseldrehung (D) gedreht wird.

6. Verfahren nach einem der Ansprüche 1 bis 5, wobei mittels einer passiven Nachheizvorrichtung (220) ein Temperaturgradient in radialer (R_{R}) und axialer Richtung (R_{R}) des Einkristalls (110), gleichmäßig über den Umfang des Einkristalls (100) verteilt reduziert wird.

7. Anlage (200) mit einer elektromagnetischen Schmelzvorrichtung (210) zum Ziehen eines Einkristalls (103) nach dem FZ-Verfahren, umfassend eine Zusatzheizvorrichtung (230), die eine in Umfangsrichtung (Ru) des Einkristalls (110) auftretende, ungleichmäßige Verteilung einer Temperatur des Einkristalls (110) ausgleicht, **gekennzeichnet durch** eine Regelungseinrichtung, die einen Wärmeeintrag der Zusatzheizvorrichtung (230) auf kältere Positionen des Umfangs des Einkristalls beschränkt.

8. Anlage (200) nach Anspruch 7, **gekennzeichnet durch** eine Laserlichtquelle (232) als Zusatzheizvorrichtung (230).

9. Anlage (200) nach Anspruch 7 oder Anspruch 8, **gekennzeichnet durch** eine Ausgestaltung der Regelungseinrichtung, welche die Zusatzheizvorrichtung (230) abwechselnd aktiviert und deaktiviert, um die Positionen von Ziehkanten selektiv zu erhitzen.

## Claims

1. Method of pulling a single crystal (103) by the FC method, in which a rod of polycrystalline semiconductor material (101) is melted by means of a electromagnetic melting device (210) and subsequently crystallized out as a single crystal, wherein an uneven distribution of the temperature of the single crystal (103) occurring in the circumferential direction (R_{U} ) of the single crystal (103) is at least partially compensated by means of an additional heating device (230), **characterized in that** the single crystal (100) is additionally heated selectively at colder positions of its circumference by means of the additional heating device (230).

2. Method according to claim 1, **characterized in that** the single crystal (100) is additionally heated selectively at positions of drawing edges (110) by means of the additional heating device (230).

3. Method according to claim 1 or 2, **characterized in that** the colder positions are determined by measuring the temperature.

4. Method according to any one of claims 1 to 3, wherein an auxiliary heating device (230) is used comprising a laser light source (232) whose laser light (238) is directed to the single crystal (100) by means of at least one optical device (234).

5. Method according to any one of claims 1 to 4, wherein the single crystal (103) is rotated by means of alternating rotation (D).

6. Method according to any one of claims 1 to 5, wherein a temperature gradient in radial (R_{R} ) and axial direction (R_{R} ) of the single crystal (110), uniformly distributed over the circumference of the single crystal (100), is reduced by means of a passive post-heating device (220).

7. An apparatus (200) having an electromagnetic melting device (210) for pulling a single crystal (103) by the FC method, comprising an auxiliary heating device (230) which compensates for an uneven distribution of a temperature of the single crystal (110) occurring in a circumferential direction (R_{U} ) of the single crystal (110), **characterized by** a control means which limits a heat input of the auxiliary heating device (230) to colder positions of the circumference of the single crystal.

8. Apparatus (200) according to claim 7, **characterized by** a laser light source (232) as auxiliary heating device (230) .

9. Apparatus (200) according to claim 7 or claim 8, **characterized by** an embodiment of the control means that alternately activates and deactivates the auxiliary heating device (230) to selectively heat the positions of drawing edges.

## Revendications

1. Procédé de tirage d'un monocristal (103) selon le procédé FZ, dans lequel une barre de matériau semi-conducteur polycristallin (101) est fondue au moyen d'un dispositif de fusion électromagnétique (210) et est ensuite cristallisée sous forme de monocristal, dans lequel, au moyen d'un dispositif de chauffage supplémentaire (230), une répartition non uniforme de la température du monocristal (103), apparaissant dans la direction périphérique (R_{U} ) du monocristal (103), est au moins partiellement compensée, **caractérisé en ce que** le monocristal (100) est chauffé sélectivement en plus à des positions plus froides de sa périphérie au moyen du dispositif de chauffage supplémentaire (230).

2. Procédé selon la revendication 1, **caractérisé en ce que** le monocristal (100) est chauffé de manière supplémentaire de manière sélective à des positions d'arêtes de tirage (110) au moyen du dispositif de chauffage supplémentaire (230).

3. Procédé selon la revendication 1 ou 2, **caractérisé en ce que** les positions les plus froides sont déterminées en mesurant la température.

4. Procédé selon l'une des revendications 1 à 3, dans lequel on utilise un dispositif de chauffage additionnel (230) comprenant une source de lumière laser (232) dont la lumière laser (238) est dirigée vers le monocristal (100) au moyen d'au moins un dispositif optique (234).

5. Procédé selon l'une quelconque des revendications 1 à 4, dans lequel le monocristal (103) est mis en rotation au moyen d'une rotation alternée (D).

6. Procédé selon l'une des revendications 1 à 5, dans lequel, au moyen d'un dispositif de post-chauffage passif (220), on réduit un gradient de température dans la direction radiale (R_{R} ) et dans la direction axiale (R_{R} ) du monocristal (110), réparti uniformément sur la périphérie du monocristal (100).

7. Appareil (200) avec un dispositif de fusion électromagnétique (210) pour le tirage d'un monocristal (103) selon le procédé FZ, comprenant un dispositif de chauffage supplémentaire (230) qui compense une répartition non uniforme d'une température du monocristal (110) se produisant dans la direction périphérique (R_{U} ) du monocristal (110), **caractérisée par** un dispositif de régulation qui limite un apport de chaleur du dispositif de chauffage supplémentaire (230) à des positions plus froides de la périphérie du monocristal.

8. Appareil (200) selon la revendication 7, **caractérisée par** une source de lumière laser (232) comme dispositif de chauffage supplémentaire (230) .

9. Appareil (200) selon la revendication 7 ou la revendication 8, **caractérisée par** une configuration du dispositif de régulation qui active et désactive alternativement le dispositif de chauffage supplémentaire (230) pour chauffer sélectivement les positions des arêtes d'emboutissage.
